Europäisches Patentamt

European Patent Office

Office européen des brevets

(11) Veröffentlichungsnummer: **0 250 976**
**A1**

(12) **EUROPÄISCHE PATENTANMELDUNG**

(21) Anmeldenummer: 87108479.4

(22) Anmeldetag: 12.06.87

(51) Int. Cl.⁴: **G06F 15/62** , G09G 1/16 , G11C 8/00

(30) Priorität: 23.06.86 DE 3620932

(43) Veröffentlichungstag der Anmeldung:
07.01.88 Patentblatt 88/01

(84) Benannte Vertragsstaaten:
**BE DE FR GB IT NL**

(71) Anmelder: **Siemens Aktiengesellschaft Berlin und München**
**Wittelsbacherplatz 2**
**D-8000 München 2(DE)**

(72) Erfinder: **Helma, Hans**
**Hagsfelder Allee 10**
**D-7500 Karlsruhe(DE)**
Erfinder: **Kick, Horst**
**Am Schäferloch 26**
**D-7519 Walzbachtal 2(DE)**

(54) **Anordnung zum Verarbeiten von Bilddaten.**

(57) Es ist bekannt, Bilddaten in einem Bildspeicher (BSP1) derart zu speichern, daß jedem Bildpunkt eine Speicherzelle zugeordnet ist. Die Adressen für den Bildspeicher werden von Adressenzählern (AZ1, AZ2) geliefert, die entsprechend den Bildschirmkoordinaten je einer Koordinatenrichtung zugeordnet sind. Gemäß der vorliegenden Erfindung können die Bilddaten nicht nur in der Reihenfolge, in der die Bilddaten eingeschrieben wurden, aus dem Bildspeicher (BSP1) ausgelesen werden, sondern auch in anderen Reihenfolgen. Hierzu ist eine Zählersteuerung vorgesehen, welche wahlweise die Zählrichtung eines oder beider Zähler umschaltet und die Zähler parallel oder in gewünschter Reihenfolge hintereinanderschaltet.

Die Erfindung wird angewand bei Bildanalysegeräten.

FIG 1

EP 0 250 976 A1

## Anordnung zum Verarbeiten von Bilddaten

Die Erfindung betrifft eine Anordnung zum Verarbeiten von Bilddaten gemäß dem Oberbegriff des Anspruchs 1. Eine derartige Anordnung ist aus den Zeitschriften "Elektronik" 1985, Heft 5, Seiten 93 und 94 und "Der Elektroniker" 1985, Heft 1, Seiten 59 bis 67 bekannt. Die bekannten Anordnungen enthalten mehrere Prozessoren, welche die von einer Kamera gelieferten oder aus einem Bildspeicher ausgelesenen Bilddaten verarbeiten. Solange die Bilddaten aus dem Speicher in derselben Reihenfolge ausgelesen werden wie sie eingeschrieben wurden, ergeben sich keine Probleme. Anders ist es dagegen, wenn die Reihenfolge geändert werden soll und hierzu jede Adresse umständlich per Software errechnet werden muß.

Der vorliegenden Erfindung liegt die Aufgabe zugrunde, eine Anordnung der im Oberbegriff des Anspruchs 1 angegebenen Art zu schaffen, mit der die in einem Bildspeicher eingetragenen Daten rasch, auch mit der Bildpunktfrequenz, in geänderter Reihenfolge ausgelesen werden können.

Erfindungsgemäß wird diese Aufgabe mit den in den kennzeichnenden Teilen der Ansprüche 1 und 4 angegebenen Maßnahmen gelöst. Mit der Lösung nach Anspruch 1 wird erreicht, daß, wenn die ausgelesenen Bilddaten auf einem Sichtgerät dargestellt werden, das dargestellte Bild gegenüber dem ursprünglichen um ± 90° oder 180° gedreht und noch zusätzlich gespiegelt ist. Bei Parallelschaltung der Zähler findet eine diagonale Abtastung statt. Die Lösung nach Anspruch 4 gestattet, die Bilddaten in beliebiger wählbarer Reihenfolge ohne Belastung des Prozesses auszulesen.

Anhand der Zeichnungen, in denen Ausführungsbeispiele der Erfindung dargestellt sind, werden im folgenden Weiterbildungen, Ergänzungen und Vorteile der Erfindung näher beschrieben und erläutert.

Es zeigen

Figur 1 ein Übersichtsschaltbild einer Bildauswerteanlage,

Figur 2 ein Blockschaltbild der Ansteuerung eines Bildspeichers,

Figur 3 Einzelheiten der Adressenbildung für den Bildspeicher,

Figur 4 eine Anordnung zum Bilden der Bildspeicheradresse in beliebiger Reihenfolge.

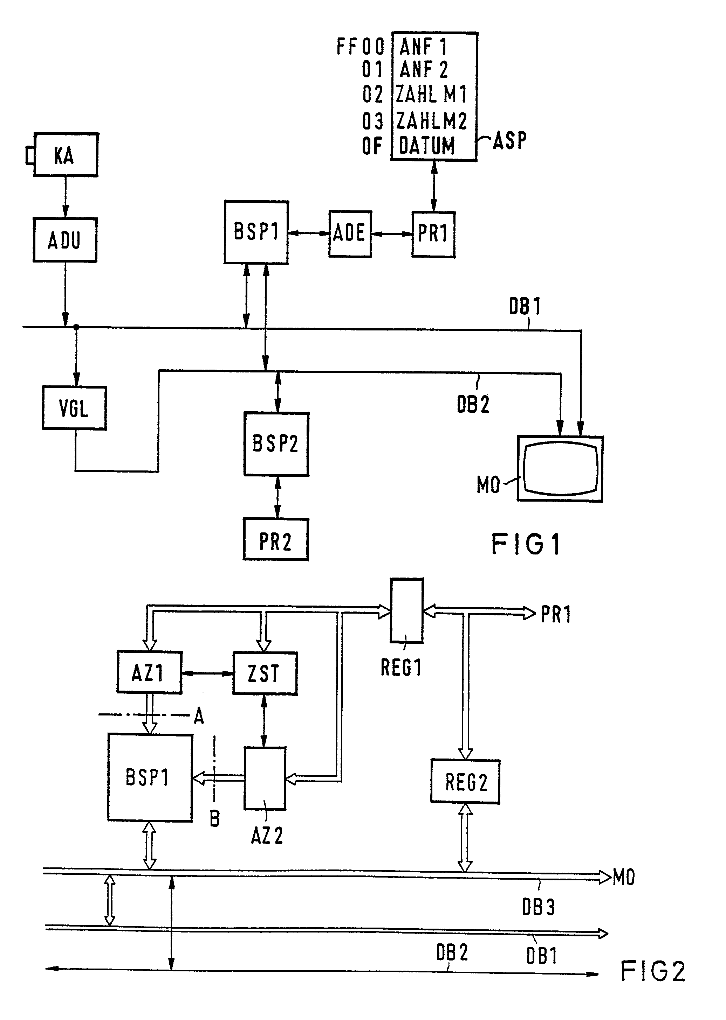

In Figur 1 ist mit KA eine Fernsehkamera bezeichnet, an die ein Analog-Digital-Umsetzer ADU angeschlossen ist, der die analogen Videosignale der Kamera in Digitalsignale umsetzt. Diese werden auf eine Busleitung DB1 gegeben, an die zwei Bildspeicher BSP1, BSP2 und ein Monitor MO angeschlossen sind. Jeder Bildspeicher ist mit einem Prozessor PR1, PR2 verbunden, von denen der Prozessor PR2 vor allem der Bildauswertung dient, während der Prozessor PR1 die im Bildspeicher BSP1 enthaltenen Daten vorverarbeitet. Der Arbeitsspeicher des Prozessors ist mit ASP bezeichnet. Zwischen den Prozessor PR1 und den Bildspeicher BSP1 ist eine Adressiereinheit geschaltet, die, vom Prozessor PR1 parametriert, die Adressen für den Bildspeicher BSP1 erzeugt. Ebenfalls der Vorverarbeitung dient ein Vergleicher VGL, der an die Busleitung angeschlossen ist, der aus den Bilddaten durch Vergleich mit einem Schwellwert oder durch Vergleich von je zwei aufeinanderfolgenden Bilddaten binäre Bilddaten erzeugt, die über eine Busleitung DB2 in einem der Bildspeicher BSP1, BSP2 eingetragen werden können. Die in den Bildspeichern enthaltenen Daten sowie die Ausgangssignale des Analog-Digital-Umsetzers ADU können mit dem Monitor MO dargestellt werden.

In Figur 2 ist mit BSP1 wieder der erste Bildspeicher bezeichnet. Die Adressen werden ihm als zwei Teiladressen zugeführt, von denen die erste in einem ersten Adressenzähler AZ1 und die zweite in einem zweiten Adressenzähler AZ2 gebildet werden. Diese Zähler sind voreinstellbare Zweirichtungszähler. Eine Zählersteuerung ZST steuert nicht nur die Zählrichtungen, sondern sie gibt auch an, ob die Zähler parallel oder hintereinandergeschaltet sind und in welcher Reihenfolge sie hintereinandergeschaltet sind. Die Informationen hierzu erhält sie über ein Register REG1 vom Prozessor PR1. Die Datenein-und -ausgänge des Bildspeichers BSP1 sind mit einer Busleitung DB3 verbunden, an die ferner über ein Register REG2 der Prozessor PR1 angeschlossen ist. Über diese Busleitung können die Bilddaten auch zum Monitor MO übertragen werden. Die Busleitung DB3 steht außerdem über Register REG3, REG4 mit den Leitungen DB1, DB2 in Verbindung.

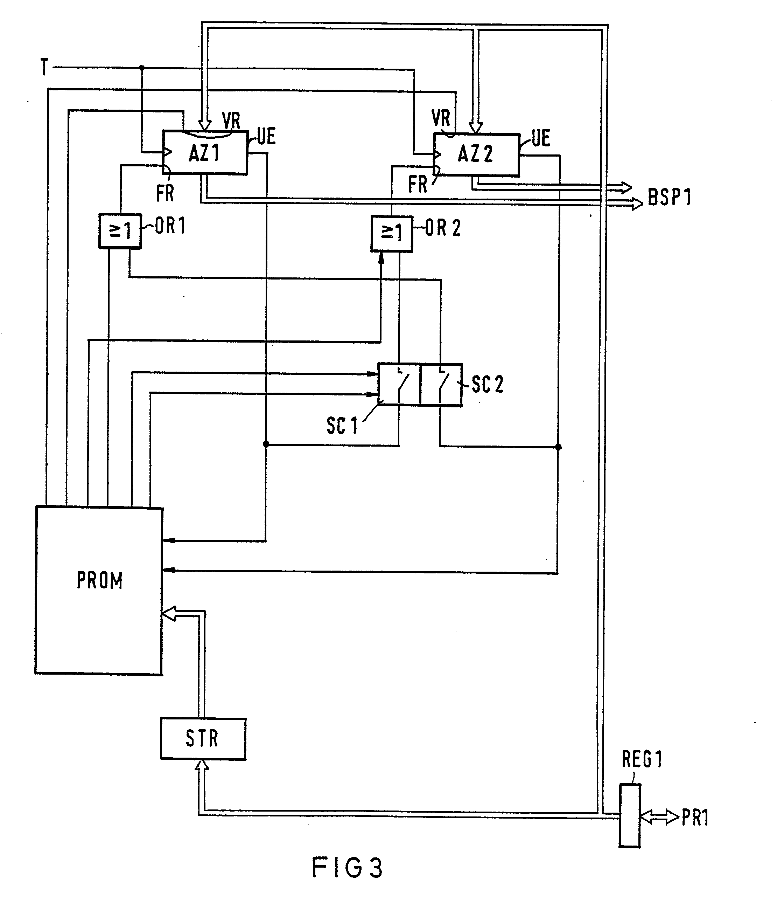

Figur 3 zeigt Einzelheiten der in Figur 2 nur als Block dargestellten Zählersteuerung ZST. Über das Register REG1 werden vom Prozessor PR1 aus dessen Arbeitsspeicherzellen FF00, FF01 (siehe Figur 1) die Anfangszählerstände für die Adressenzähler AZ1, AZ2 eingetragen. Danach wird in das Steuerregister STR aus der Arbeitsspeicherzelle FF10 der Zählmodus eingeschrieben. Dieser wird als Teiladresse einem Festwertspeicher PROM zugeführt. Vervollständigt wird diese Teiladresse mit den Übertragimpulsen der Zähler AZ1, AZ2. An die Ausgänge des Festwertspeiches PROM sind die Steuereingänge VR für Vorwärts- und Rückwärtszählung der Zähler AZ1, AZ2 angeschlossen. Zwei weitere Ausgänge des Festwertspeichers PROM sind auf zwei ODER-Glieder OR1, OR2 geführt, an welche die Freigabeeingänge FR der Zähler AZ1, AZ2 an geschlossen sind. Es kann somit entweder der Zähler AZ1 oder der Zähler AZ2, oder es können beide Zähler gleichzeitig zum Zählen von Triggerimpulsen T freigegeben werden. Die Triggerimpulse können entweder Bildpunktfrequenz haben, so daß die Videosignale der Kamera KA (Figur 1) unmittelbar in den Bildspeicher BSP1 eingetragen werden können oder die im Bildspeicher BSP1 enthaltenen Daten auf dem nach dem Zeilenrasterverfahren arbeitenden Sichtgerät MO dargestellt werden können. Für die Bildauswertung im Prozessor PR1 werden die Triggerimpulse T jeweils bei einem Zugriff des Prozessors zum Bildspeicher BSP1 gebildet.

Mit zwei weiteren Ausgangssignalen des Festwertspeichers PROM werden zwei Schalter SC1, SC2 gesteuert. Mit dem Schalter SC1 können die Übertragimpulse des Adressenzählers AZ1 über das ODER-Glied OR2 dem Freigabeeingang FR des Adressenzählers AZ2 zugeführt werden. Dieser Zähler ist somit dem Zähler AZ1 nachgeschaltet, wenn der Schalter SC1 geschlossen ist. Entsprechend werden bei geschlossenem Schalter SC2 die Übertragimpulse des Zählers AZ2 dem freigabeeingang des Zählers AZ1 zugeführt. Sind beide Schalter geöffnet, arbeiten die beiden Zähler unabhängig voneinander, sofern man von der Kopplung über den Festwertspeicher PROM absieht.

Der Einfachheit halber wird angenommen, daß im Meßfeld eines Bildes die Anzahl der Bildpunkte je Zeile gleich der Anzahl der Zeilen im Meßfeld ist. Die Kapazität der Adressenzähler AZ1, AZ2 ist gleich der Bildpunktzahl je Zeile bzw. der Zeilenzahl im Meßfeld. Zum Einschreiben eines Bildes in den Bildspeicher BSP1 ist der Schalter SC1 geschlossen, beide Zähler werden vor dem Einschreiben auf Null gestellt, und je Bildpunkt im Meßfeld wird ein Triggerimpuls erzeugt, wobei die Triggerimpulsfrequenz gleich der Bildpunktfrequenz ist. Demgemäß gibt der Stand des Adressenzählers AZ1 die Spalte des jeweils abgetasteten Bildpunktes an und der Zähler AZ2 die Zeile, die gerade abgetastet wird. Sieht man den Bildspeicher als zweidimensional an, dann wird in ihm ein Abbild des aufgenommenen Bildes eingetragen. Dieses Abbild wird unverändert ausgelesen und auf dem Monitor dagestellt, wenn die Zähler AZ1, AZ2 in derselben Weise wie beim Einschreiben des Bildes betrieben werden, d. h., wenn der Schalter SC1 geschlossen ist, dem Zähler AZ1 konstant ein Freigabesignal zugeführt ist und beide Zähler auf Vorwärtszählung eingestellt sind.

Durch Verändern der Steuerung der Zähler kann das ausgelesene Abbild gegenüber dem ursprünglichen Bild in verschiedener Weise verändert werden, und zwar kann es um ±90° oder 180° gedreht, es kann an einer in Zeilenrichtung verlaufenden Geraden, einer dazu senkrecht verlaufenden Geraden oder auch an den Bilddiagonalen gespiegelt und entsprechend dargestellt werden. Auch ist eine diagonale Abtastung des Abbildes und die Auswertung der so vorverarbeiteten Bilddaten möglich. Beispielsweise wird das Bild um + 90° gedreht, wenn der Zähler AZ1 dem Zähler AZ2 nachgeschaltet und der Zähler AZ2 auf Rückwärtszählen eingestellt wird. Zur Spiegelung an der durch die Bildmitte laufenden vertikalen Gerade wird der Zähler AZ1 zur Spiegelung an der durch die Bildmitte verlaufenden horizontalen Gerade der Zähler AZ2 rückwärts gezählt.

Bei der diagonalen Abtastung erhalten beide Zähler gleichzeitig die Triggerimpulse. Bei Erreichen des Meßfeldrandes, das ist der Zählerstand Null und der maximale Zählerstand, wird der Zählmodus verändert. Hierzu werden die Übertragimpulse dem Festwertspeicher PROM zugeführt, der darauf den neuen Zählmodus ausgibt. Auch in dieser Betriebsart können die Zähler wahlweise auf Vor-oder Rückwärtszählung eingestellt werden.

Wie schon erwähnt, erfolgt der Zugriff des Prozessors PR1 auf den Bildspeicher BSP1 in der Weise, daß der gewünschte Zählmodus in die Zelle FF02 eingetragen und diese Zelle adressiert wird. Der Zählmodus wird darauf in das Steuerregister STR übernommen. Der Inhalt der adressierten Zelle des Speichers BSP1 wird in den Arbeitsspeicher ASP des Prozessors PR1 eingetragen und kann dort mit anderen Bilddaten verglichen werden. Je nach Ergebnis erfolgt ein neuer Zugriff auf die Zelle FF02 mit demselben Zählmodus oder es wird ein neuer Zählmodus gewählt, sei es dadurch, daß dieser zuvor in die Zelle FF02 eingetragen wurde oder daß je Zählmodus eine Speicherzelle vorgesehen ist, z. B. die Zellen 03, 04 ... und die Zelle mit dem gewünschten Modus aufgerufen werden. Auf diese Weise kann man in dem Abbild z. B. Konturen, Linien gleichen Grauwertes und dergleichen verfolgen. Auch können die aus dem Bildspeicher BSP1 ausgelesenen Bilddaten in den Bildspeicher BSP2 zur weiteren Auswertung mit dem Prozessor PR2 übertragen werden. Die Abtastung des im Speicher BSP1 enthaltenen Abbildes in verschiedenen Richtungen stellt dann eine rasche Vorverarbeitung der Bilddaten dar.

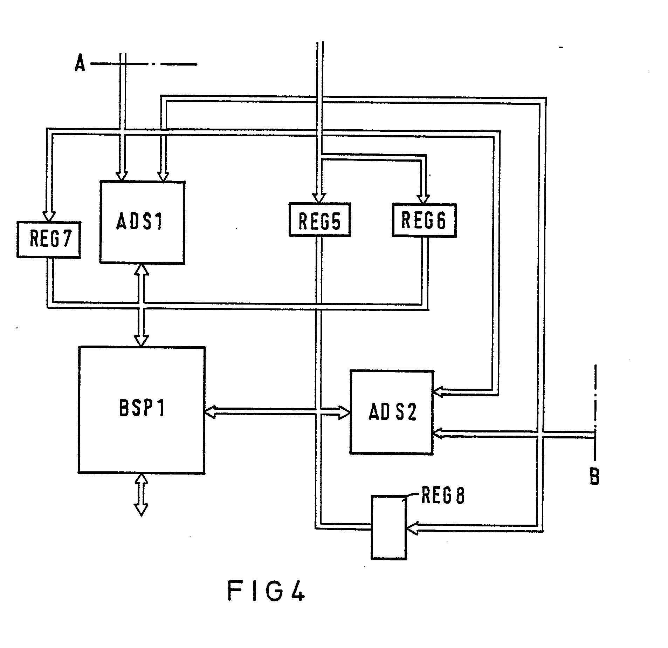

Die bisher beschriebene Anordnung zeichnet sich durch ihre Einfachheit aus. Auch können die Bilddaten aus dem Speicher BSP1 mit hoher Frequenz in unterschiedlicher Reihenfolge ausgelesen werden. Allerdings ist die Reihenfolge des Auslesens durch die Anzahl der Zählmodi begrenzt. Eine frei wählbare Reihenfolge der ausgelesenen Bilddaten läßt sich mit einer Schaltungsergänzung erreichen, deren Blockschaltbild in Figur 4 dargestellt ist. Diese Schaltung wird an den in Figur 2 mit A und B markierten Stellen eingefügt. Sie besteht im wesentlichen aus zwei Adressenspeichern ADS1, ADS2, die mit den jeweiligen Ständen der Zähler AZ1, AZ2 adressiert sind und an deren Datenausgänge die Adresseneingänge des Bildspeichers BSP1 angeschlossen sind. Die Adressenspeicher ADS1, ADS2 sind Speicher mit wahlfreiem Zugriff, die über Register REG5, REG6 mit Adressen für den Bildspeicher BSP1 vom Prozessor PR1 geladen werden können. Über zwei Register REG7, REG8 kann der Bildspeicher BSP1 weiterhin direkt von den Zählern AZ1, AZ2 adressiert werden. Der Einsatz der beiden Adressenspeicher ADS1, ADS2 gestattet, die zugeführten Zählerstände, das sind, wenn beide Zähler in Vorwärtsrichtung zählen und der Zähler AZ2 dem Zähler AZ1 nachgeschaltet ist, die Koordinaten des Meßfeldes in beliebiger Weise zu verändern und somit eine beliebige Koordinatentransformation durchzuführen. Selbstverständlich können auch noch zusätzlich die oben beschriebenen Zählerstandsmodifikationen durchgeführt werden.

## Ansprüche

1. Anordnung zum Verarbeiten von Bilddaten mit einem Bildspeicher, in dem die Bilddaten gespeichert sind, wobei jedem Bildpunkt eine Speicherzelle zugeordnet ist, mit einem ersten und einem zweiten Adressenzähler, denen der Adresseneingang des Bildspeichers nachgeschaltet ist, und mit einem Prozessor, der wahlfreien Zugriff zum Bildspeicher hat, **dadurch gekennzeichnet,** daß die Adressenzähler (AZ1, AZ2) vom Prozessor (PR1) voreinstellbare Zweirichtungszähler sind, die vom Prozessor (PR1) über eine Zählersteuerung (ZST) wahlweise parallel oder in wählbarer Reihenfolge hintereinander schaltbar sind und deren Zählrichtung vom Prozessor PR1 über die Zählersteuerung (ZST) eingestellt ist.

2. Anordnung nach Anspruch 1, **dadurch gekennzeichnet,** daß die Zählersteuerung (ZST) einen Festwertspeicher (PROM) enthält, dem die jeweiligen Zählrichtungen und die jeweilige Zählerschaltung codiert als Adresse zugeführt ist und von dessen Ausgangssignalen die Adressenzähler (AZ1, AZ2) und Schaltmittel (SC1, SC2), welche die Adressenzähler (AZ1, AZ2) in Reihe oder parallel schalten, gesteuert sind.

3. Anordnung nach Anspruch 2, **dadurch gekennzeichnet,** daß die Übertragimpulse der Adressenzähler (AZ1, AZ2) als Teiladresse dem Festwertspeicher (PROM) zugeführt sind.

4. Anordnung zum Verarbeiten von Bilddaten mit einem Bildspeicher, in dem die Bilddaten gespeichert sind, wobei jedem Bildpunkt eine Speicherzelle zugeordnet ist, mit einem ersten und einem zweiten Adressenzähler, denen der Adresseneingang des Bildspeichers nachgeschaltet ist, und mit einem Prozessor, der wahlfreien Zugriff zum Bildspeicher hat, **dadurch gekennzeichnet,** daß zwischen die Adressenzähler (AZ1, AZ2) und den Adresseneingang des Bildspeichers (BSP1) je ein Adressenumsetzer geschaltet ist.

5. Anordnung nach Anspruch 4, **dadurch gekennzeichnet,** daß die Adressenumsetzer aus je einem Adressenspeicher (ADS1, ADS2) bestehen, deren Adresseneingänge an die Adressenzähler (AZ1, AZ2) und deren Ausgänge mit dem Adresseneingang des Bildspeichers (BSP1) verbunden sind und die vom Prozessor PR1 ladbar sind.

86 P 4421

| FF00 | ANF 1 |
|------|-------|
| 01 | ANF 2 |
| 02 | ZAHL M1 |
| 03 | ZAHLM2 |
| 0F | DATUM |

ASP

KA

ADU

BSP1 ← ADE ← PR1

DB1

VGL

DB2

BSP2

MO

PR2

FIG1

REG1

PR1

AZ1 ↔ ZST

A

BSP1 ← AZ2

B

REG2

MO

DB3

DB2    DB1

FIG2

0 250 976

86 P 4421

FIG 3

86 P 4421

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-3 976 982 (EISELEN)<br>* Zusammenfassung; Spalte 2, Zeilen 23-26; Spalte 3, Zeile 55 - Spalte 4, Zeile 21; Spalte 4, Zeile 62 - Spalte 5, Zeile 41; Spalte 6, Zeilen 15-30; Spalte 6, Zeile 40 - Spalte 8, Zeile 56; Spalte 10, Zeilen 47-51; Figuren 1,7,8 * | 1 | G 06 F 15/62<br>G 09 G 1/16<br>G 11 C 8/00 |
| A | | 2,3 | |
| | --- | | |
| X | FR-A-2 574 575 (O'DONNELL)<br>* Zusammenfassung; Seite 3, Zeile 20 - Seite 4, Zeile 11; Seite 6, Zeile 17 - Seite 7, Zeile 23; Seite 9, Zeile 27 - Seite 10, Zeile 13; Seite 12, Zeilen 28-35; Figuren 1,3,4 * | 1 | |
| A | | 2-4 | RECHERCHIERTE SACHGEBIETE (Int. Cl.4)<br><br>G 06 F<br>G 09 G<br>G 11 C |
| | --- | | |
| X | US-A-4 168 488 (EVANS)<br>* Zusammenfassung; Spalte 2, Zeilen 26-38; Spalte 5, Zeile 45 - Spalte 6, Zeile 21; Spalte 7, Zeile 49 - Spalte 8, Zeile 54; Figuren 1,10 * | 1 | |
| | ---     -/- | | |

Der vorliegende Recherchenbericht wurde für alle Patentansprüche erstellt.

| Recherchenort | Abschlußdatum der Recherche | Prüfer |
|---|---|---|
| DEN HAAG | 23-07-1987 | WEBER, V.G.E. |

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 124 871 (MORIN, II) <br> * Zusammenfassung; Spalte 1, Zeilen 37-54; Spalte 2, Zeile 40 - Spalte 3, Zeile 28; Spalte 5, Zeile 47 - Spalte 7, Zeile 24; Figuren 2-4 .* | 1,4 | |
| A | | 5 | |
| | ----- | | |

RECHERCHIERTE
SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 23-07-1987 | WEBER, V.G.E. |

EPA Form 1503 03 82